(19) Europäisches Patentamt | European Patent Office | Office européen des brevets

(11) **EP 3 678 295 B1**

(12) **EUROPEAN PATENT SPECIFICATION**

(45) Date of publication and mention
of the grant of the patent:
**09.03.2022 Bulletin 2022/10**

(21) Application number: **18851212.3**

(22) Date of filing: **23.05.2018**

(51) International Patent Classification (IPC):
*G01R 1/20* (2006.01)     *G01R 19/00* (2006.01)
*H03K 17/08* (2006.01)     *H03K 17/687* (2006.01)
*H03K 17/082* (2006.01)     *H03K 17/14* (2006.01)

(52) Cooperative Patent Classification (CPC):
**G01R 1/203; G01R 19/0092; H03K 17/08;**
**H03K 17/082; H03K 17/14; H03K 17/687;**
H03K 2217/0027

(86) International application number:
**PCT/JP2018/019850**

(87) International publication number:
**WO 2019/044068 (07.03.2019 Gazette 2019/10)**

(54) **SEMICONDUCTOR RELAY AND VEHICLE CURRENT DETECTION DEVICE**

HALBLEITERRELAIS UND FAHRZEUGSTROMDETEKTOR

RELAIS À SEMI-CONDUCTEUR ET DISPOSITIF DE DÉTECTION DE COURANT DE VÉHICULE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **30.08.2017 JP 2017165795**
                    **25.10.2017 JP 2017205964**

(43) Date of publication of application:
**08.07.2020 Bulletin 2020/28**

(73) Proprietor: **Yazaki Corporation**
**Minato-ku**
**Tokyo 108-8333 (JP)**

(72) Inventors:
• **OISHI, Eiichiro**
  **Susono-shi**
  **Shizuoka 410-1194 (JP)**
• **MORIMOTO, Mitsuaki**
  **Susono-shi**
  **Shizuoka 410-1194 (JP)**

(74) Representative: **Grünecker Patent- und**
**Rechtsanwälte**
**PartG mbB**
**Leopoldstraße 4**
**80802 München (DE)**

(56) References cited:
EP-A1- 2 933 643       JP-A- H11 326 400
JP-A- 2009 011 112     JP-A- 2014 075 297
US-A1- 2013 229 186    US-B2- 6 845 301

**Description**

The present invention relates to a semiconductor relay and a vehicle current detection device.

Background

A high-voltage relay configured to connect or cut off a high-voltage battery and a load is mounted on a vehicle such as an electric vehicle (EV), a hybrid electric vehicle (HEV), or a plug-in hybrid electric vehicle (PHEV) (refer to Patent Literature 1). In Patent Literature 1, a current sensor is mounted to manage charging and discharging of the high-voltage battery and detect anomalous current flowing to the high-voltage relay. A typical current detection method is a method using a shunt resistor (refer to Patent Literature 2). Further aspects related to the protection of electrical components and the detection of currents are disclosed in Patent Literatures 3 to 5.

Patent Literature 1: Japanese Patent Application Laid-open No. 2012-85504
Patent Literature 2: Japanese Patent Application Laid-open No. H7-177751
Patent Literature 3: US 2013/229186 A1
Patent Literature 4: US 6 845 301 B2
Patent Literature 5: EP 2 933 643 A1

Summary

However, since a current sensor is installed separately from a high-voltage relay, components included in the current sensor need to be added, which leaves room for improvement. In addition, loss of electrical power occurs when a shunt resistor is installed on a path through which large current flows.
The present invention is intended to provide a semiconductor relay and a vehicle current detection device that can efficiently detect current at a high-voltage circuit without increase in the number of components.
This is achieved by the features of the independent claim.
A semiconductor relay and a vehicle current detection device according to the present invention can detect current at a high-voltage circuit without increase in the number of components.

FIG. 1 is a block diagram illustrating a schematic configuration of a vehicle current detection device according to a first embodiment, not covered by the claimed invention.
FIG. 2 is an exploded perspective view illustrating a schematic configuration of the vehicle current detection device according to the first embodiment.
FIG. 3 is an exterior diagram of a semiconductor relay according to the first embodiment.
FIG. 4 is a partially enlarged diagram illustrating a schematic configuration of the semiconductor relay according to the first embodiment.
FIG. 5 is a diagram illustrating of a schematic configuration of the semiconductor relay according to the first embodiment.
FIG. 6 is a schematic configuration diagram of a voltage detection section according to the first embodiment.
FIG. 7 is a diagram illustrating a temperature characteristic of the voltage detection section according to the first embodiment.
FIG. 8 is a diagram illustrating of a schematic configuration of a semiconductor relay according to a second embodiment, covered by the claimed invention.
FIG. 9 is a diagram for describing anomaly detection based on current values on input and output sides according to the second embodiment.
FIG. 10 is a diagram illustrating of a schematic configuration of a detection section according to a modification of the embodiment.
FIG. 11 is a block diagram illustrating a schematic configuration of a vehicle current detection device according to a third embodiment, not covered by the claimed invention.
FIG. 12 is an exploded perspective view illustrating a schematic configuration of the vehicle current detection device according to the third embodiment.
FIG. 13 is a block diagram illustrating a schematic configuration of a semiconductor relay according to the third embodiment.
FIG. 14 is a perspective view illustrating a schematic configuration of the semiconductor relay according to the third embodiment.
FIG. 15 is a plan view illustrating a schematic configuration of the semiconductor relay according to the third embodiment.

FIG. 16 is a side view illustrating a schematic configuration of the semiconductor relay according to the third embodiment.

FIG. 17 is a partial longitudinal sectional view illustrating a schematic configuration of the semiconductor relay according to the third embodiment.

FIG. 18 is a schematic configuration diagram of a voltage detection section according to the third embodiment.

FIG. 19 is a diagram illustrating a temperature characteristic of the voltage detection section according to the third embodiment.

Embodiments of a semiconductor relay and a vehicle current detection device according to the present invention or useful to understand the present invention will be described below in detail with reference to the accompanying drawings. The present invention is not limited to the present embodiments. Components in the following embodiments include those that can be easily thought of by the skilled person in the art or those that are identical in effect. Components in the following embodiments may be omitted, replaced, and changed in various kinds of manners without departing from the scope of the invention. In addition, configurations described below may be combined with each other as appropriate.

[First embodiment, not covered by the claimed invention]

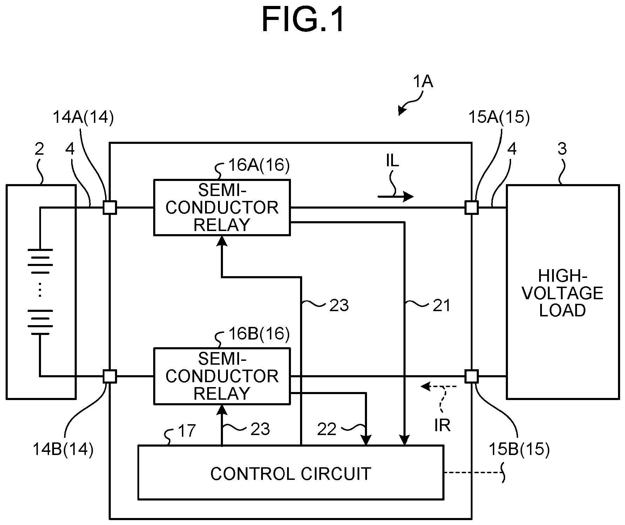

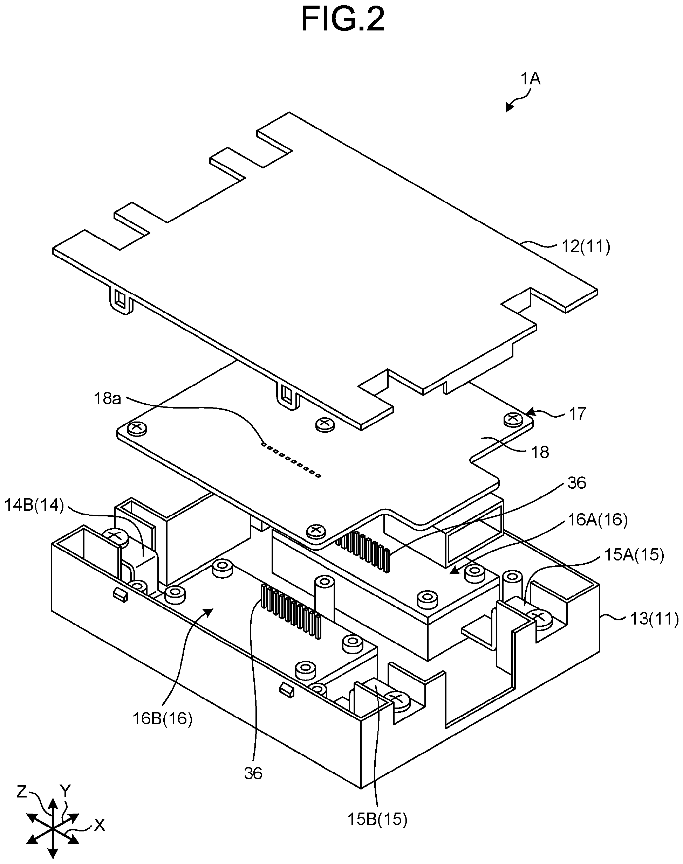

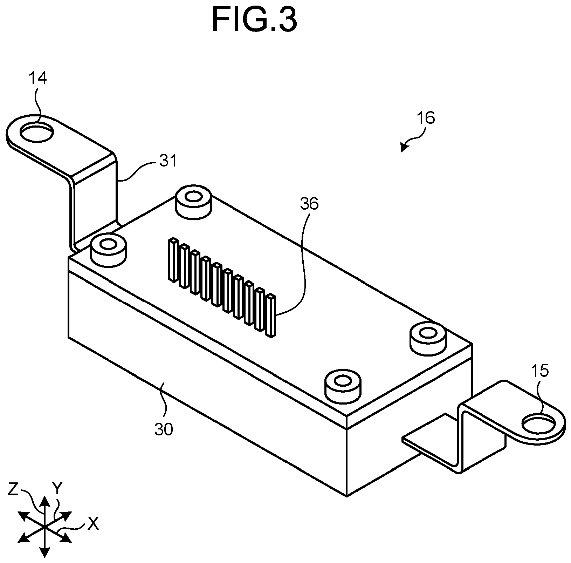

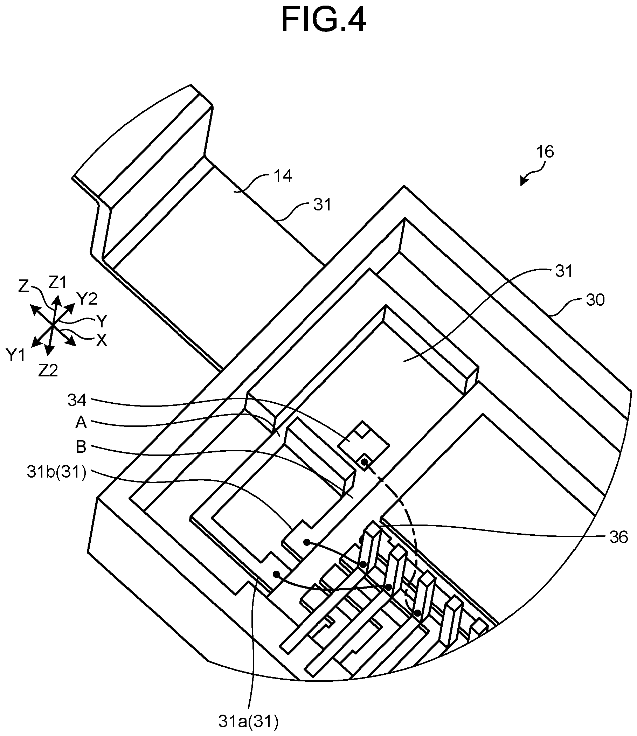

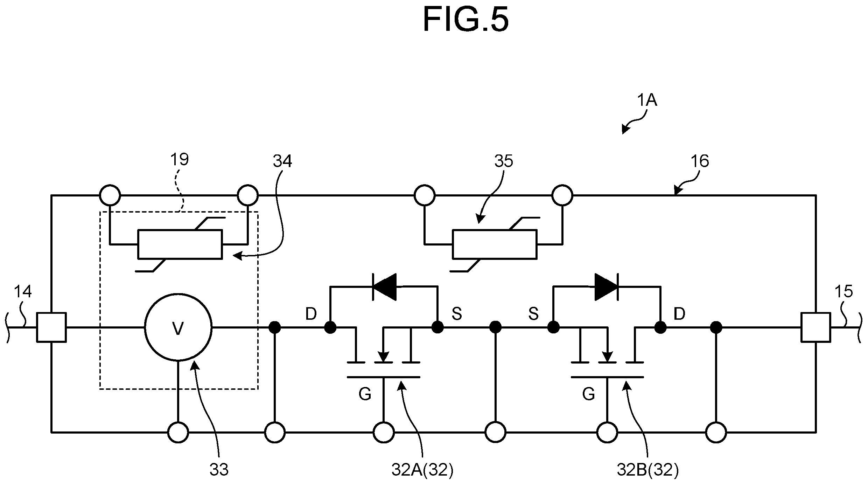

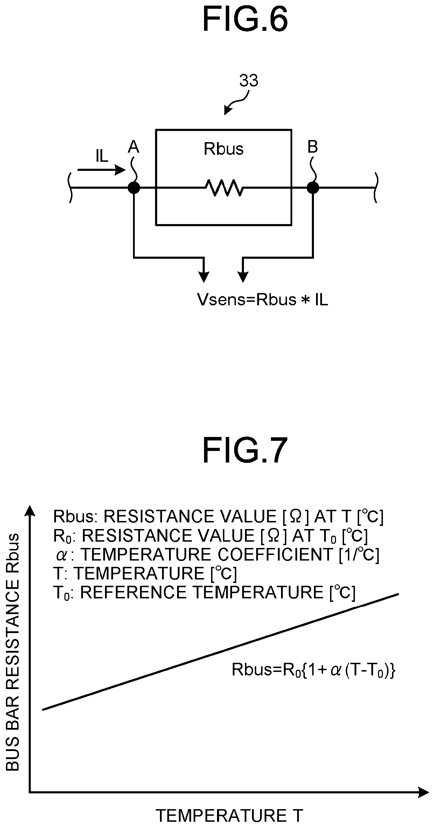

FIG. 1 is a block diagram illustrating a schematic configuration of a vehicle current detection device according to a first embodiment, not covered by the claimed invention. FIG. 2 is an exploded perspective view illustrating a schematic configuration of the vehicle current detection device according to the first embodiment. FIG. 3 is an exterior diagram of a semiconductor relay according to the first embodiment. FIG. 4 is a partially enlarged diagram illustrating a schematic configuration of the semiconductor relay according to the first embodiment. FIG. 5 is a diagram illustrating of a schematic configuration of the semiconductor relay according to the first embodiment. FIG. 6 is a schematic configuration diagram of a voltage detection section according to the first embodiment. FIG. 7 is a diagram illustrating a temperature characteristic of the voltage detection section according to the first embodiment. FIG. 4 is a diagram illustrating a state in which a case cover is removed to externally expose the internal space. The X direction in FIGS. 2 to 4 is a width direction of the vehicle current detection device in the present embodiment. The Y direction is a depth direction of the vehicle current detection device in the present embodiment, and is a direction orthogonal to the width direction. The Y1 direction is defined to be a front direction, and the Y2 direction is defined to be a back direction. The Z direction is an up-down direction of the vehicle current detection device in the present embodiment, and is a direction orthogonal to the width direction and the depth direction. The Z1 direction defines an upward direction, and the Z2 direction defines a downward direction.

A vehicle current detection device 1A according to the present embodiment is an electrical connection box mounted on a vehicle such as an electric vehicle (EV), a hybrid electric vehicle (HEV), or a plug-in hybrid electric vehicle (PHEV). As illustrated in FIG. 1, the vehicle current detection device 1A is disposed between a high-voltage battery 2 and a high-voltage load 3 and performs electrical connection and electrical cutoff between the high-voltage battery 2 and the high-voltage load 3. In the following description, the electrical connection is also simply referred to as "connection", and the electrical cutoff is also simply referred to as "cutoff".

The high-voltage battery 2 is a high-voltage power source mounted on the above-described vehicle and configured to supply electrical power to the high-voltage load 3. The high-voltage battery 2 is, for example, an assembled battery in which a plurality of battery cells are connected with each other, and supplies direct-current power. The high-voltage battery 2 is not limited to an assembled battery but may be any form that can supply direct-current power. The high-voltage battery 2 is connected with a pair of input-side terminals 14A (14) and 14B (14) on the vehicle current detection device 1A side.

The high-voltage load 3 is mounted on the above-described vehicle and operates with supply of direct-current power from the high-voltage battery 2. The high-voltage load 3 includes, for example, an inverter. The high-voltage load 3 is connected with a pair of output-side terminals 15A (15) and 15B (15) on the vehicle current detection device 1A side.

The vehicle current detection device 1A includes a pair of semiconductor relays 16A and 16B and a control circuit 17. The pair of semiconductor relays 16A and 16B and the control circuit 17 are housed in a housing 11. As illustrated in FIG. 2, the housing 11 includes an upper cover 12 and a lower cover 13. The upper cover 12 and the lower cover 13 are made of insulating synthesis resin or the like.

The pair of semiconductor relays 16A and 16B are each disposed on an electric path 4 between the high- voltage battery 2 and the high-voltage load 3 and open and close the electric path 4. The semiconductor relays 16A and 16B can each bi-directionally perform cutoff (opening) and energization (closing) and include, for example, a plurality of MOS-FETs. The semiconductor relay 16A is disposed on the positive electrode side of the high-voltage battery 2 and serves as part of the electric path 4 on the positive electrode side. The semiconductor relay 16A is connected with the input-side terminal 14A on one side and connected with the output-side terminal 15A on the other side, and performs electric cutoff or energization of the electric path 4 on the positive electrode side. The semiconductor relay 16A is connected with the control circuit 17 and outputs a positive-electrode-side signal 21 to the control circuit 17. The positive-electrode-side signal 21 includes, for example, potential difference information detected by a voltage detection section 33 to be described later, and temperature information detected by a first temperature sensor 34 and a second temperature sensor 35. The semiconductor relay 16A receives a control signal 23 input from the control circuit 17, and drives based on the control signal 23. The semiconductor relay 16A opens and closes the electric path 4 on the positive electrode side based on, for example, the control signal 23. The semiconductor relay 16B is disposed on the negative electrode side of the high-voltage battery 2 and serves as part of the electric path 4 on the negative electrode side. The semiconductor relay 16B is connected with the input-side terminal 14B on one side and connected with the output-side terminal 15B on the other side, and performs electric cutoff or energization of the electric path 4 on the negative electrode side. The semiconductor relay 16B is connected with the control circuit 17 and outputs a negative-electrode-side signal 22 to the control circuit 17. Similarly to the positive-electrode-side signal 21, the negative-electrode-side signal 22 includes, for example, potential difference information detected by the voltage detection section 33, and temperature information detected by the first temperature sensor 34 and the second temperature sensor 35. The semiconductor relay 16B receives the control signal 23 input from the control circuit 17 and drives based on the control signal 23. The semiconductor relay 16B opens and closes the electric path 4 on the negative electrode side based on, for example, the control signal 23. When the semiconductor relays 16A and 16B are in the closed state, load current IL flows through the electric path 4 on the positive electrode side, and a feedback current IR flows through the electric path 4 on the negative electrode side. The closed state of the semiconductor relays 16A and 16B means that the semiconductor relays 16A and 16B are in an on state and the electric path 4 are energized. The opened state of the semiconductor relays 16A and 16B means that the semiconductor relays 16A and 16B are in the off state and the electric path 4 is cut off. The feedback current IR has a value equal to that of the load current IL, for example, when the semiconductor relays 16A and 16B are in the normal state.

As illustrated in FIGS. 3 to 5, the semiconductor relays 16A and 16B each include a bus bar 31, a pair of switching elements 32A (32) and 32B (32), the voltage detection section 33, the first temperature sensor 34, and the second temperature sensor 35. The bus bar 31, the pair of switching elements 32A and 32B, the voltage detection section 33, the first temperature sensor 34, and the second temperature sensor 35 are housed in a relay housing 30 made of insulating synthesis resin or the like. As illustrated in FIG. 3, the relay housing 30 is provided with a plurality of control terminals 36 erected on a cover on the upper surface side. Each control terminal 36 is, for example, a pin terminal and is connected with a control substrate 18 by inserting an end part thereof into a through-hole 18a of the control substrate 18 to be described later.

The bus bar 31 is a conductive member serving as part of the electric path 4 and having a resistance value that changes in accordance with temperature change. The bus bar 31 is made of metallic material such as copper alloy. One end part of the bus bar 31 in the width direction serves as the input-side terminal 14, and the other end part serves as the output-side terminal 15. A pair of contact portions 31a and 31b extending from the bus bar 31 in the front direction (Y1 direction) are formed at a part of the bus bar 31 which is housed in the relay housing 30. The contact portions 31a and 31b are each bonded to optional one of the control terminals 36. The contact portions 31a and 31b are provided to detect the potential difference between two points AB on the bus bar 31 when the semiconductor relay 16 is in the closed state. Thus, Point A and Point B on the bus bar 31 are preferably located at positions where the potential difference can be detected.

The pair of switching elements 32A and 32B are each a semiconductor switching element disposed on the electric path 4 and configured to open and close the electric path 4. The switching elements 32A and 32B are each achieved by, for example, an electrical power metal-oxide-semiconductor field-effect transistor (MOS-FET) as a kind of field effect transistor. As illustrated in FIG. 5, the sources (S) of the pair of switching elements 32 are connected in series with each other so that the directions of parasitic diodes thereof are opposite to each other. The switching element 32A is provided so that the cathode of the parasitic diode is on the high-voltage battery 2 side. The switching element 32B is provided so that the cathode of the parasitic diode is on the high-voltage load 3 side. With this configuration, the flow of electrical power between the high-voltage battery 2 and the high-voltage load 3 is cut off when the pair of switching elements 32A and 32B are in the off state. The switching elements 32A and 32B are each bonded to optional one of the control terminals 36.

The voltage detection section 33 is a detection section and detects potential difference Vsens between the two points AB on the bus bar 31 as illustrated in FIG. 6. The potential difference Vsens is the potential difference between the contact portions 31a and 31b. The voltage detection section 33 is connected with the control terminals 36 and connected with the control circuit 17 through the control terminals 36. The voltage detection section 33 outputs the potential difference Vsens to the control circuit 17.

The first temperature sensor 34 is a detection section and detects the temperature of the bus bar 31. As illustrated in FIG. 4, the first temperature sensor 34 is disposed on, for example, the bus bar 31. The first temperature sensor 34 is connected with the control terminals 36 and connected with the control circuit 17 through the control terminals 36. The first temperature sensor 34 outputs the temperature of the bus bar 31 to the control circuit 17. The first temperature sensor 34 and the voltage detection section 33 in the present embodiment serve as a detection section 19. The detection section 19 detects a physical quantity related to the load current IL flowing through the electric path 4. Examples of the physical quantity related to the load current IL flowing through the electric path 4 include the potential difference Vsens between the two points AB on the bus bar 31 which is detected by the voltage detection section 33, and the temperature of the bus bar 31 which is detected by the first temperature sensor 34.

The second temperature sensor 35 detects the temperature of each switching element 32. The second temperature sensor 35 is disposed, for example, near the pair of switching elements 32. The second temperature sensor 35 is connected with any one of the control terminals 36 and connected with the control circuit 17 through the control terminal 36. The second temperature sensor 35 outputs the temperature of the switching element 32 to the control circuit 17.

The control circuit 17 is mounted on the control substrate 18 and mainly achieved by, for example, a microcomputer. The control circuit 17 outputs the control signal 23 for controlling drive of each of the semiconductor relays 16A and 16B to the semiconductor relays 16A and 16B, respectively. For example, the control signal 23 causes the pair of semiconductor relays 16A and 16B to perform energization and cutoff of the electric path 4. The control circuit 17 can output the control signal 23 based on the positive-electrode-side signal 21 input from the semiconductor relay 16A and/or the negative-electrode-side signal 22 input from the semiconductor relay 16B. The control circuit 17 may output the control signal 23 based on, for example, a control signal received from the outside of the vehicle current detection device 1A. The control circuit 17 in the present embodiment calculates the load current IL based on Expression (1) below by using a resistance value Rbus and the potential difference Vsens between the two points AB on the bus bar 31. The resistance value Rbus can be obtained from a temperature characteristic of the resistance value Rbus of the bus bar 31 as illustrated in FIG. 7. In the temperature characteristic illustrated in FIG. 7, the vertical axis represents the resistance value Rbus [Ω] of the bus bar 31, and the horizontal axis represents the temperature T [°C] of the bus bar 31. When Ro [Ω] represents the resistance value of the bus bar 31 at To [°C], $\alpha$ [1/°C] represents a temperature coefficient, T [°C] represents the temperature of the bus bar 31 detected by the first temperature sensor 34, and $T_0$ [°C] represents a reference temperature of the bus bar 31, the resistance value Rbus at T [°C] is expressed by Expression (2) below. The bus bar 31 in the present embodiment has a temperature characteristic that the resistance value Rbus increases as the temperature increases. The potential difference Vsens is detected by the control circuit 17 connected through the control terminals 36.

$$IL = Vsens/Rbus \qquad \qquad ...(1)$$

$$Rbus = R_0\{1 + \alpha(T - T_0)\} \qquad \qquad ...(2)$$

The following describes exemplary current detection operation by the vehicle current detection device 1A according to the present embodiment. The control circuit 17 identifies the opened and closed states of the semiconductor relays 16A and 16B based on the positive-electrode-side signal 21 and the negative-electrode-side signal 22, and determines whether the electric path 4 is energized. Subsequently, while the electric path 4 is energized, the control circuit 17 acquires, from each of the positive-electrode-side signal 21 and the negative-electrode-side signal 22, the potential difference information detected by the voltage detection section 33 and the temperature information detected by the first temperature sensor 34. The control circuit 17 specifies each resistance value Rbus of the bus bar 31 from the temperature characteristic of the resistance value Rbus of the bus bar 31, which is illustrated in FIG. 7, based on the temperature T of the bus bar 31 indicated by the corresponding temperature information. Subsequently, the control circuit 17 calculates the load current IL based on each resistance value Rbus and the potential difference Vsens between the two points AB on the bus bar 31 which is indicated by each potential difference information. The control circuit 17 controls drive of the semiconductor relays 16A and 16B by, for example, outputting the control signal 23 based on the load current IL to the semiconductor relays 16A and 16B. The feedback current IR has a value equal to that of the load current IL and thus can be calculated by the above-described method.

As described above, the semiconductor relay 16 according to the present embodiment includes the semiconductor switching element 32 disposed on the electric path 4 between the high-voltage battery 2 and the high-voltage load 3 and configured to open and close the electric path 4. Accordingly, the semiconductor relay 16 has higher reliability and a longer lifetime than that of a conventional mechanical relay. In addition, since the semiconductor relay 16 according to the present embodiment includes the detection section 19 configured to detect a physical quantity related to the load current IL flowing through the electric path 4, no detection section needs to be additionally provided outside, and thus current at a high-voltage circuit can be detected without increase in the number of components. Moreover, no space in which the detection section is disposed is needed, making size reduction possible.

The semiconductor relay 16 according to the present embodiment also includes the bus bar 31 serving as part of the electric path 4 and having a resistance value that changes in accordance with temperature change, and the detection section 19 includes the first temperature sensor 34 configured to detect the temperature of the bus bar 31, and the voltage detection section 33 configured to detect the potential difference Vsens between two points on the bus bar 31. Accordingly, current flowing through the electric path 4 can be detected by using the bus bar 31. In addition, the resistance value Rbus between two points AB on the bus bar 31 can be accurately detected by using the temperature characteristic of the resistance value Rbus of the bus bar 31. As a result, the load current IL can be easily calculated based on the resistance value Rbus and the potential difference Vsens. In addition, since the load current IL can be detected without using a shunt resistor, electrical power loss can be reduced.

The vehicle current detection device 1A according to the present embodiment also includes the semiconductor relay 16, and the control circuit 17 configured to control the semiconductor relay 16. The control circuit 17 detects the load current IL flowing through the electric path 4 based on each physical quantity detected by the detection section 19. Accordingly, current at a high-voltage circuit can be efficiently detected without increase in the number of components.

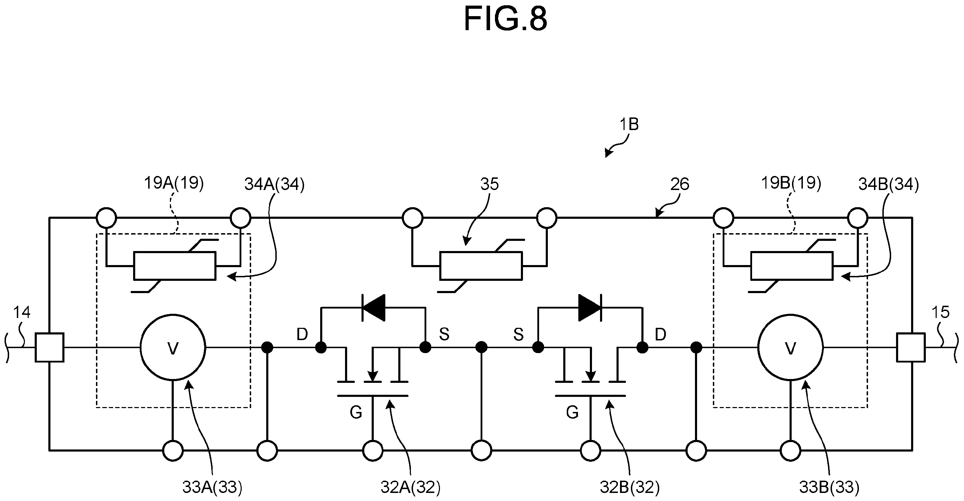

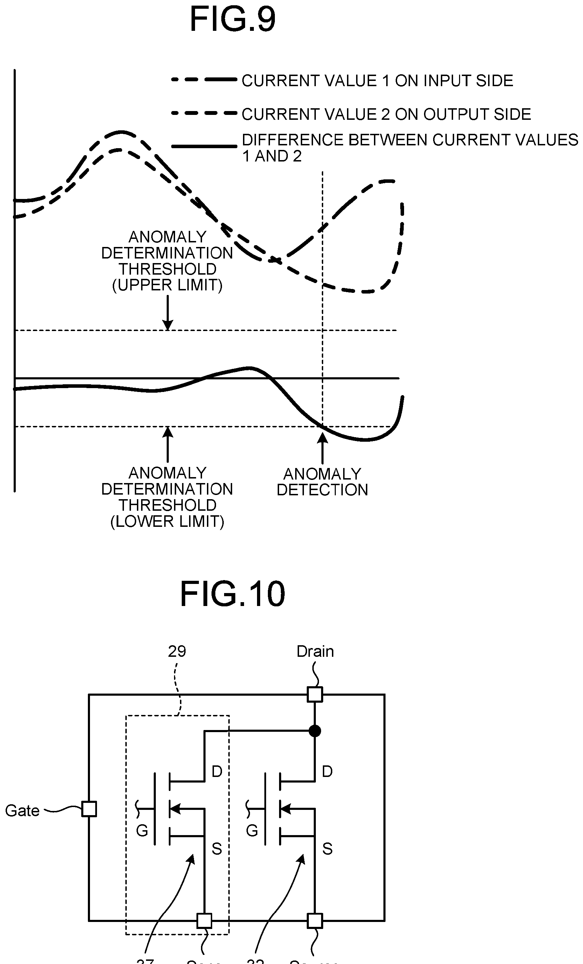

[Second embodiment, covered by the claimed invention] The following describes a semiconductor relay and a vehicle current detection device according to a second embodiment, covered by the claimed invention, with reference to FIGS. 8 and 9. FIG. 8 is a diagram illustrating of a schematic configuration of the semiconductor relay according to the second embodiment. FIG. 9 is a diagram for describing anomaly detection based on current values on input and output sides according to the second embodiment.

A vehicle current detection device 1B according to the second embodiment is different from the above-described vehicle current detection device 1A according to the first embodiment in that a semiconductor relay 26 includes a plurality of detection sections 19A and 19B. In the following description, any component common to that in the above-described first embodiment is denoted by an identical reference sign, and description thereof will be omitted.

The vehicle current detection device 1B in the second embodiment includes a pair of semiconductor relays 26 and the control circuit 17. Each semiconductor relay 26 includes the bus bar 31, the pair of switching elements 32A and 32B, a pair of voltage detection sections 33A (33) and 33B (33), a pair of first temperature sensors 34A (34) and 34B (34), and the second temperature sensor 35. The first temperature sensor 34A and the voltage detection section 33A in the present embodiment serve as the detection section 19A. The first temperature sensor 34B and the voltage detection section 33B serve as the detection section 19B. The detection section 19A and the detection section 19B are disposed on the electric path 4 with the pair of switching elements 32A and 32B interposed therebetween. The detection section 19A is formed on the input-side terminal 14 side on the bus bar 31 as illustrated in FIG. 4. The detection section 19B is disposed on the output-side terminal 15 side, which is opposite to the input-side terminal 14, on the bus bar 31.

The following describes exemplary anomaly detection operation by the vehicle current detection device 1B according to the present embodiment. The semiconductor relay 26 describes below is disposed on the electric path 4 on the positive electrode side unless otherwise stated, and the same applies to the semiconductor relay 26 disposed on the electric path 4 on the negative electrode side.

The control circuit 17 performs the anomaly detection operation based on the positive-electrode-side signal 21 received from the semiconductor relay 26 while the electric path 4 is energized. The control circuit 17 acquires the potential difference information and the temperature information detected by the detection sections 19A and 19B from the positive-electrode-side signal 21. The potential difference information includes the potential difference information detected by each of the voltage detection sections 33A and 33B. The temperature information includes the temperature information detected by each of the first temperature sensors 34A and 34B. The control circuit 17 specifies the resistance value Rbus corresponding to each of the detection sections 19A and 19B from the temperature characteristic illustrated in FIG. 7 based on the temperature T of the bus bar 31 indicated by the temperature information of each of the detection sections 19A and 19B. The resistance value Rbus corresponding to the detection section 19A is referred to as the resistance value Rbus on the input side, and the corresponding potential difference Vsens is referred to as Vsens on the input side. The resistance value Rbus corresponding to the detection section 19B is referred to as the resistance value Rbus on the output side, and the corresponding potential difference Vsens is referred to as the potential difference Vsens on the output side.

Subsequently, the control circuit 17 calculates a current value 1 on the input side and a current value 2 on the output side by using the above-described Expressions (1) and (2), based on the specified resistance values Rbus on the input and output sides and the potential differences Vsens on the input and output sides. The current value 1 on the input side and the current value 2 on the output side are the load current IL and exhibit substantially identical waveforms as illustrated in FIG. 9 when the semiconductor relay 26 is normal. For example, when anomaly has occurred to any one of the pair of switching elements 32A and 32B, the difference between the current value 1 on the input side and the current value 2 on the output side increases. The control circuit 17 compares the current value 1 on the input side and the current value 2 on the output side, and determines that the semiconductor relay 26 is anomalous when the difference therebetween exceeds an anomaly determination threshold. The anomaly determination threshold includes upper and lower limit thresholds, for example, as illustrated in FIG. 9.

As described above, in the vehicle current detection device 1B according to the present embodiment, the semiconductor relay 26 includes the two detection sections 19A and 19B on the electric path 4 with the switching element 32 interposed therebetween. Accordingly, when anomaly has occurred to any one of the two detection sections 19A and 19B, current detection can be performed by the normal one, and thus redundancy of a current detection function in the vehicle current detection device 1B can be increased without increase in the number of components. In addition, anomaly of the semiconductor relay 26 can be determined by comparing the difference between the current values 1 and 2 obtained by the two detection sections 19A and 19B to the anomaly determination threshold.

In the above-described second embodiment, the control circuit 17 performs the anomaly determination operation while the electric path 4 is energized. However, the present invention is not limited thereto, and the anomaly determination operation may be performed while the electric path 4 is cut off. Accordingly, it is possible to detect, for example, anomaly of leakage current when the semiconductor relay 26 is in the opened state.

In the above-described second embodiment, the control circuit 17 detects anomaly of the semiconductor relay 26 by comparing the difference between the current value 1 on the input side and the current value 2 on the output side to the anomaly determination threshold, but the present invention is not limited thereto. For example, the anomaly detection may be performed by comparing potential differences (voltages) detected by the voltage detection sections 33A and 33B, respectively.

In the above-described first and second embodiments, current flowing through the electric path 4 is detected through calculation by the control circuit 17 based on a physical quantity obtained from the detection section 19, but the present invention is not limited thereto. FIG. 10 is a diagram illustrating a schematic configuration of a detection section according to a modification of the embodiment. A detection section 29 according to the modification of the present embodiment is a shunt switching element 37 connected in parallel with the switching element 32. The detection section 29 branches current flowing through the electric path 4 into the switching element 32 and the shunt switching element 37, and detects the load current IL flowing through the electric path 4 based on shunt current flowing through the shunt switching element 37. Similarly to the switching element 32, the detection section 29 is achieved by, for example, a MOS-FET. In the detection section 29, shunt current branched from the drain side of the switching element 32 flows toward a terminal on the Sens side. The shunt current is set to be, for example, 1/5000 of current flowing between the drain and the source. The terminal on 5 the Sens side is connected with the control terminals 36 and connected with the control circuit 17 through the control terminals 36. Accordingly, the load current IL flowing through the electric path 4 can be easily detected. In addition, the contact portions 31a and 31b of the bus 10 bar 31 and the first temperature sensor 34 are not mounted, and thus reduction can be achieved in size and cost of the detection section 19 that detects current.

In the above-described first and second embodiments, the first temperature sensor 34 is disposed on 15 the bus bar 31 as illustrated in FIG. 4, but is not limited to the illustrated example, and may be disposed at any position where the first temperature sensor 34 can detect the temperature of the bus bar 31. The second temperature sensor 35 is disposed near the pair of switching elements 20 32, but may be disposed at any position where the second temperature sensor 35 can detect the temperature of the switching element 32.

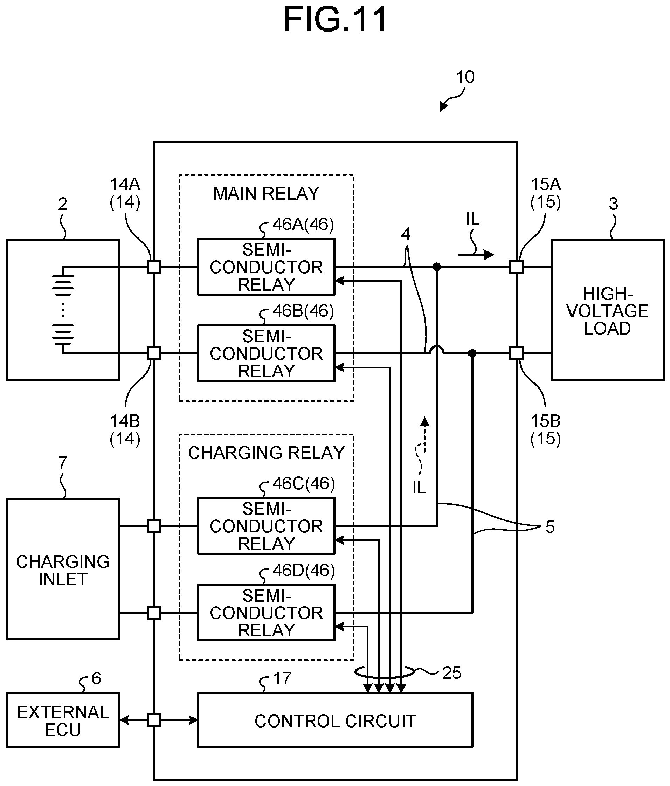

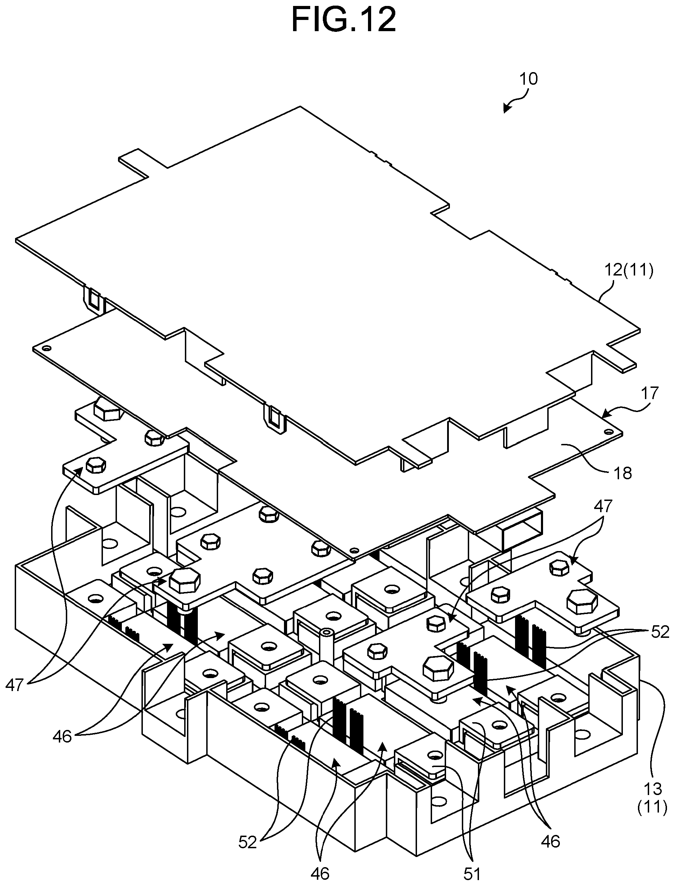

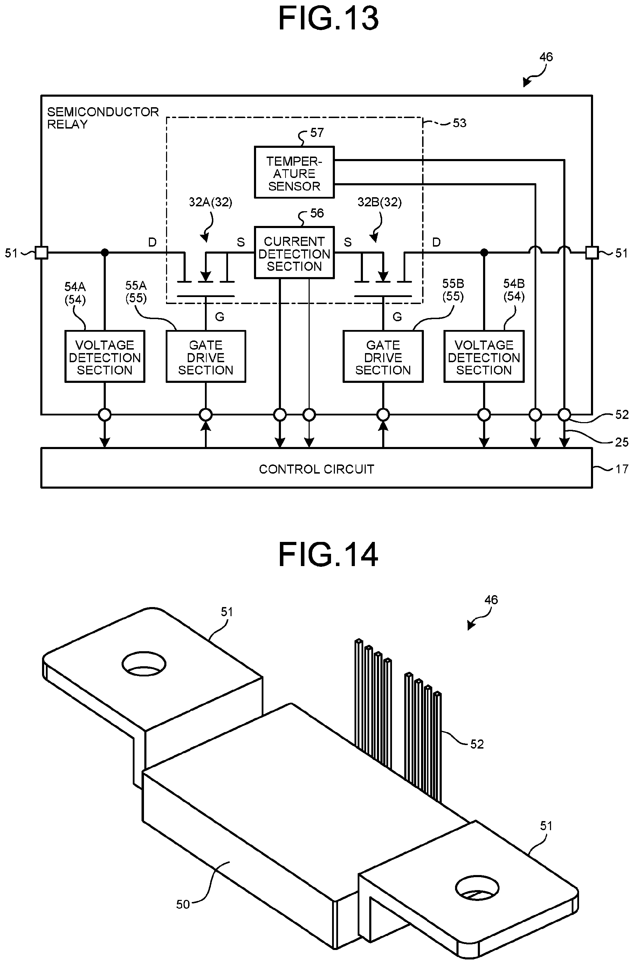

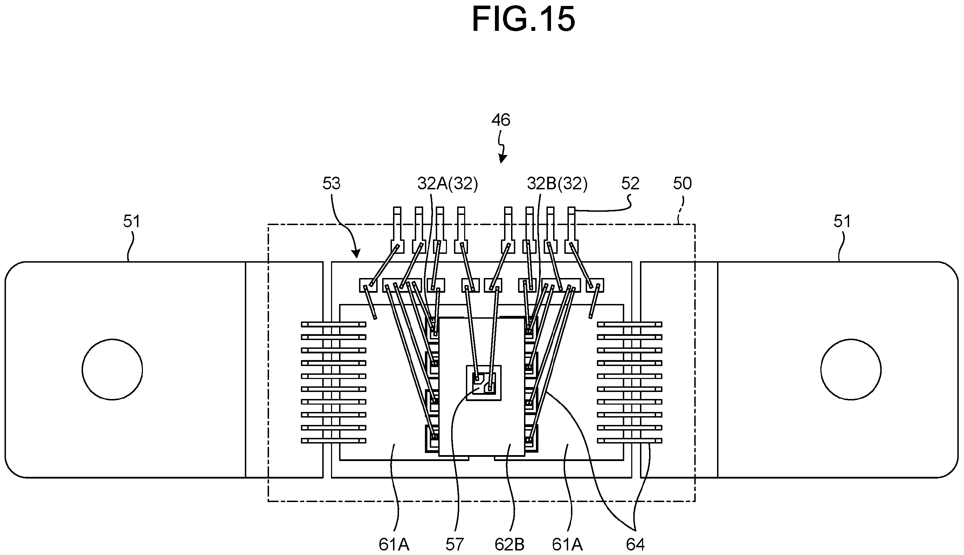

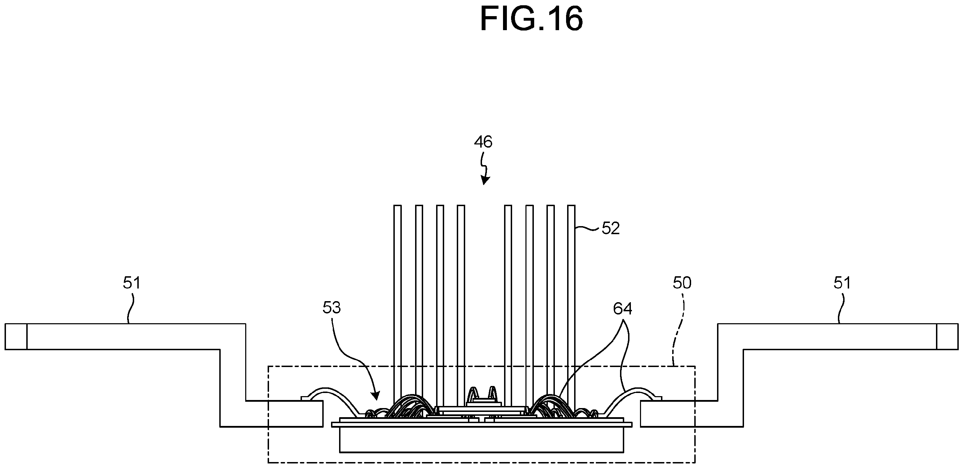

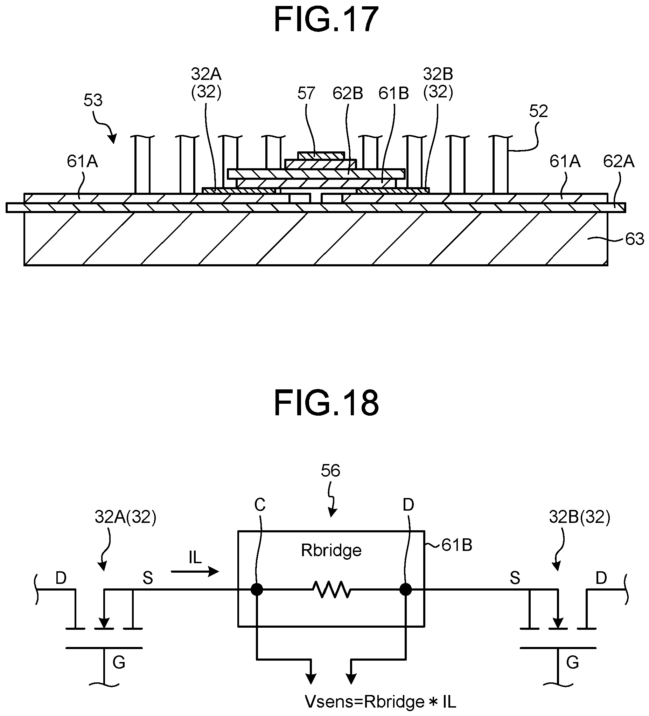

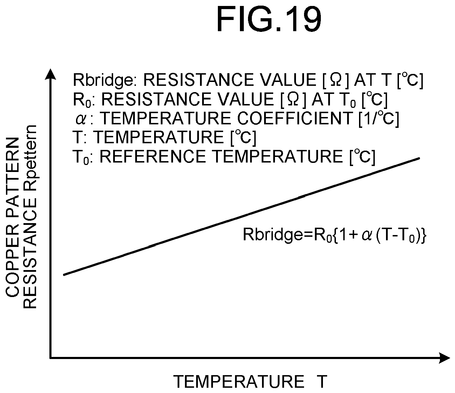

[Third embodiment, not covered by the claimed invention] The following describes a semiconductor relay and a 25 vehicle current detection device according to a third embodiment, not covered by the claimed invention, with reference to FIGS. 11 to 19. FIG. 11 is a block diagram illustrating a schematic configuration of the vehicle current detection device according to the third embodiment. FIG. 12 is an 30 exploded perspective view illustrating a schematic configuration of the vehicle current detection device according to the third embodiment. FIG. 13 is a block diagram illustrating a schematic configuration of the semiconductor relay according to the third embodiment. FIG. 14 is a perspective view illustrating a schematic configuration of the semiconductor relay according to the third embodiment. FIG. 15 is a plan view illustrating a schematic configuration of the semiconductor relay according to the third embodiment. FIG. 16 is a side view illustrating a schematic configuration of the semiconductor relay according to the third embodiment. FIG. 17 is a partial longitudinal sectional view illustrating a schematic configuration of the semiconductor relay according to the third embodiment. FIG. 18 is a schematic configuration diagram of a voltage detection section according to the third embodiment. FIG. 19 is a diagram illustrating a temperature characteristic of the voltage detection section according to the third embodiment. FIGS. 15 and 16 are diagrams illustrating the semiconductor relay in a state in which a current detection unit is externally exposed. FIG. 17 is a longitudinal sectional view of the current detection unit included in the semiconductor relay, and omits part of the current detection unit.

A vehicle current detection device 10 according to the third embodiment is different from the above-described vehicle current detection device 1A according to the first embodiment mainly in that the vehicle current detection device 10 includes a charging inlet 7, an electric path 5 between the charging inlet 7 and the high-voltage battery 2, and a semiconductor relay 46 disposed on the electric path 5. In the following description, any component common to that in the above-described first embodiment is denoted by an identical reference sign, and description thereof will be omitted.

As illustrated in FIG. 11, the vehicle current detection device 10 according to the third embodiment includes the electric path 5, the charging inlet 7, and a pair of semiconductor relays 46C (46) and 46D (46) in addition to a pair of semiconductor relays 46A (46) and 46B (46) and the control circuit 17. As illustrated in FIG. 12, the four semiconductor relays 46A to 46D, part of the electric paths 4 and 5, and the control circuit 17 are housed in the housing 11 including the upper cover 12 and the lower cover 13. The four semiconductor relays 46A to 46D in the present embodiment are housed in the one housing 11.

The electric path 5 is a second electric path disposed between the high-voltage battery 2 and the charging inlet 7 with respect to the electric path 4 as a first electric path. The electric path 5 connects the charging inlet 7 and the high-voltage battery 2. Part of the electric path 5 on the high-voltage battery 2 side is shared with the electric path 4 and connected with the high-voltage load 3 through the electric path 4. For example, the electric path 5 according to the present embodiment is connected with an external power source through the charging inlet 7 and used for energization from the external power source to the high-voltage battery 2. The external power source includes, for example, a charging device. Energization current IL flows through the electric path 5, for example, while the charging inlet 7 is connected with the external power source (not illustrated) and the semiconductor relays 46C and 46D are in the closed state. The energization current IL includes charging current to the high-voltage battery 2.

The charging inlet 7 is a connection portion to be connected with the external power source, and is, for example, a charging connector. The charging inlet 7 is connected with the electric path 5 and connected with the high-voltage battery 2 through the electric path 5. The charging inlet 7 is also connected with the high-voltage load 3 through the electric path 5 and the electric path 4.

Similarly to the above-described pair of semiconductor relays 16A and 16B, the pair of semiconductor relays 46A and 46B are disposed on the electric path 4 and open and close the electric path 4 as a main relay. The pair of semiconductor relays 46C and 46D are disposed on the electric path 5 and open and close the electric path 5 as a charging relay. The semiconductor relays 46A to 46D are each closed in the on state and opened in the off state. Each of the semiconductor relays 46A to 46D is connected with the control circuit 17 through a signal line 25, and switches to the on state or the off state based on a control signal from the control circuit 17. The semiconductor relays 46A and 46B can each bi-directionally perform cutoff and energization of the corresponding electric path 4. The semiconductor relays 46C and 46D can each bi-directionally perform cutoff and energization of the corresponding electric path 5.

The semiconductor relay 46A is connected with the high-voltage battery 2 through the input-side terminal 14A on one side and connected with the high-voltage load 3 through the output-side terminal 15A on the other side. The semiconductor relay 46A is connected with the positive electrode side of the high-voltage battery 2, serves as part of the electric path 4 on the positive electrode side, and performs cutoff or connection of the electric path 4 on the positive electrode side. The semiconductor relay 46B is connected with the high-voltage battery 2 through the input-side terminal 14B on one side and connected with the high-voltage load 3 through the output-side terminal 15B on the other side. The semiconductor relay 46B is connected with the negative electrode side of the high-voltage battery 2, serves as part of the electric path 4 on the negative electrode side, and performs cutoff or connection of the electric path 4 on the negative electrode side. The semiconductor relays 46A and 46B each output a detection signal to the control circuit 17 through the signal line 25. The detection signal includes a signal indicating the opened or closed state of the corresponding one of the semiconductor relays 46A and 46B, and a temperature, a current value, a voltage value, and the like detected in the semiconductor relays 46A and 46B. The semiconductor relays 46A and 46B each open and close the corresponding electric path 4 based on a control signal from the control circuit 17.

The semiconductor relay 46C is connected with the high-voltage battery 2 through the semiconductor relay 46A on one side and connected with the charging inlet 7 on the other side. The semiconductor relay 46C is connected with the positive electrode side of the high-voltage battery 2, serves as part of the electric path 5 on the positive electrode side, and performs cutoff or connection of the electric path 5 on the positive electrode side. The semiconductor relay 46D is connected with the high-voltage battery 2 through the semiconductor relay 46B on one side and connected with the charging inlet 7 on the other side. The semiconductor relay 46D is connected with the negative electrode side of the high-voltage battery 2, serves as part of the electric path 5 on the negative electrode side, and performs cutoff or connection of the electric path 5 on the negative electrode side. The semiconductor relays 46C and 46D each output a detection signal to the control circuit 17 through the signal line 25. The detection signal includes a signal indicating the opened or closed state of the corresponding one of the semiconductor relays 46C and 46D, and a temperature, a current value, a voltage value, and the like detected in the semiconductor relays 46C and 46D. The semiconductor relays 46C and 46D each open and close the corresponding electric path 5 based on a control signal from the control circuit 17.

As illustrated in FIG. 13, the semiconductor relay 46 according to the present embodiment includes a current detection unit 53, two voltage detection sections 54A (54) and 54B (54), and two gate drive sections 55A (55) and 55B (55). The current detection unit 53, the voltage detection sections 54A and 54B, and the gate drive sections 55A and 55B are housed in a relay housing 50 illustrated in FIG. 14. The relay housing 50 is made of insulating synthesis resin or the like, and partially houses a pair of bus bar terminals 51 and a plurality of control terminals 52. The pair of bus bar terminals 51 are conductive members extending at both ends of the semiconductor relay 46 and made of, for example, copper or alloy. The bus bar terminals 51 are each connected with a bus bar 47 housed in the housing 11. The bus bar 47 serves as part of the electric paths 4 and 5 and connects, for example, the bus bar terminals 51 of the two semiconductor relays 46 on the positive electrode side or the negative electrode side. In FIG. 12, the two semiconductor relays 46 are disposed on each of the electric paths 4 and 5 on the positive electrode side and the negative electrode side to improve energization performance. In other words, the semiconductor relays 46 are connected in parallel with the electric paths 4 and 5 on the positive electrode side and the electric paths 4 and 5 on the negative electrode side. Each control terminal 52 is, for example, a pin terminal and partially exposed from a side surface of the relay housing 50. Each control terminals 52 is connected with the control circuit 17 in a state in which, for example, one side thereof is connected with the current detection unit 53 and the other side is inserted into a through-hole (not illustrated) of the control substrate 18.

The current detection unit 53 includes the pair of switching elements 32A and 32B, a current detection section 56, and a temperature sensor 57. As illustrated in FIGS. 15 to 17, the current detection unit 53 has a laminated structure with the pair of switching elements 32A and 32B at the center and is connected with, for example, each bus bar terminal 51 through a bonding wire 64.

The pair of switching elements 32A and 32B are semiconductor elements disposed on each of the electric paths 4 and 5 and configured to open and close the electric path. The pair of switching elements 32A and 32B are disposed between one of the bus bar terminals 51 and the other bus bar terminal 51 with the current detection section 56 interposed therebetween. The switching elements 32A and 32B are each achieved by, for example, an electrical power MOS-FET as described above. The switching elements 32A and 32B are each connected with an optional control terminal 52 through the bonding wire 64. As illustrated in FIG. 17, the switching elements 32A and 32B are each sandwiched between a copper pattern 61A and a copper pattern 61B in a stacking direction. The copper patterns 61A and 61B are each a conductive member having a thin plate shape and used for wiring and are made of, for example, copper or copper alloy. The copper pattern 61A is connected with the drain (D) of the corresponding one of the switching elements 32A and 32B. The copper pattern 61A is disposed on a heat-releasing pad 63 through an insulation substrate 62A having a thin plate shape. The heat-releasing pad 63 achieves heat-releasing by transferring heat generated at the switching elements 32A and 32B to an external heat sink (not illustrated). The copper pattern 61A is connected with the corresponding bus bar terminal 51 through the bonding wire 64. The copper pattern 61B serves as part of the electric path 4 or the electric path 5 and has a resistance value that changes in accordance with temperature change. The copper pattern 61B is a bridge portion and connects the sources (S) of the switching elements 32A and 32B. An insulation substrate 62B having a thin plate shape, a die bonding member, and the temperature sensor 57 are sequentially stacked on the copper pattern 61B.

The current detection section 56 is a detection section and detects a physical quantity related to the energization current IL flowing through the electric path 4 or the electric path 5. Examples of the physical quantity related to the energization current IL include the potential difference Vsens between two points CD on the copper pattern 61B. Thus, the current detection section 56 detects the potential difference Vsens between the two points CD on the copper pattern 61B as illustrated in FIG. 18. The current detection section 56 is connected with the control terminals 52 through the bonding wire 64. The current detection section 56 is connected with the control circuit 17 through the control terminals 52 and outputs the potential difference Vsens to the control circuit 17.

The temperature sensor 57 is a detection section and detects a physical quantity related to the energization current IL flowing through the electric path 4 or the electric path 5. Examples of the physical quantity related to the energization current IL include the temperature of the copper pattern 61B. Thus, the temperature sensor 57 is disposed on the copper pattern 61B and detects the temperature of the copper pattern 61B. The temperature sensor 57 is connected with the control terminals 52 and connected with the control circuit 17 through the control terminals 52. The temperature sensor 57 outputs the temperature of the copper pattern 61B to the control circuit 17.

The voltage detection sections 54A and 54B detect the voltage of the electric path 4 or the electric path 5 extending inside the semiconductor relay 46. As illustrated in FIG. 13, the voltage detection section 54A is disposed on, for example, the input side on the electric path 4 or the electric path 5 extending inside the semiconductor relay 46. The voltage detection section 54B is disposed on, for example, the output side on the electric path 4 or the electric path 5 in the semiconductor relay 46. The voltage detection sections 54A and 54B are each connected with the control circuit 17 by the signal line 25 through the corresponding control terminal 52 and output voltage values to the control circuit 17.

The gate drive sections 55A and 55B are driver circuits configured to drive the switching elements 32A and 32B. The gate drive section 55A is connected with the gate (G) of the switching element 32A and outputs a gate drive signal for driving the switching element 32A. The gate drive section 55B is connected with the gate (G) of the switching element 32B and outputs a gate drive signal for driving the switching element 32B. The gate drive sections 55A and 55B are each connected with the control circuit 17 by the signal line 25 through the corresponding control terminal 52. The gate drive sections 55A and 55B each output a gate drive signal to the corresponding one of the switching elements 32A and 32B in accordance with a control signal from the control circuit 17. The switching elements 32A and 32B each switch to the on state or the off state in accordance with the gate drive signal.

The control circuit 17 is mounted on the control substrate 18 and mainly achieved by, for example, a microcomputer. The control circuit 17 outputs a control signal for controlling drive of each of the semiconductor relays 46A to 46D to the semiconductor relays 46A to 46D. Examples of the control signal include control signals for causing the pair of semiconductor relays 46A and 46B to perform cutoff and connection of the electric path 4, and control signals for causing the pair of semiconductor relays 46C and 46D to perform cutoff and connection of the electric path 5. The control circuit 17 can output the control signal based on a detection signal input from each semiconductor relay 46. The control circuit 17 according to the present embodiment calculates the energization current IL based on Expression (3) below by using a resistance value Rbridge and the potential difference Vsens between the two points CD on the copper pattern 61B. The copper pattern 61B has a temperature characteristic that the resistance value Rbridge increases as the temperature increases. The resistance value Rbridge can be obtained from the temperature characteristic of the resistance value Rbridge of the copper pattern 61B, which is illustrated in FIG. 19. In the temperature characteristic illustrated in FIG. 19, the vertical axis represents the resistance value Rbridge [Ω] of the copper pattern 61B, and the horizontal axis represents the temperature T [°C] of the copper pattern 61B. When Ro [Ω] represents the resistance value of the copper pattern 61B at To [°C], $\alpha$ [1/°C] represents a temperature coefficient, T [°C] represents the temperature of the copper pattern 61B detected by the temperature sensor 57, and To [°C] represents a reference temperature of the copper pattern 61B, the resistance value Rbridge at T [°C] is expressed by Expression (4) below.

$$\mathtt{IL\ =\ Vsens/Rbridge} \qquad\qquad \mathtt{...(3)}$$

$$\mathtt{Rbridge\ =\ R_0\{1\ +\ \alpha(T\ -\ T_0)\}} \qquad\qquad \mathtt{...(4)}$$

The following describes exemplary current detection operation by the vehicle current detection device 10 according to the present embodiment. First, the control circuit 17 identifies the opened or closed state of each of the semiconductor relays 46A to 46D based on a received detection signal, and determines whether the electric path 4 or the electric path 5 is energized. Subsequently, while the electric path 4 or the electric path 5 is energized, the control circuit 17 acquires the potential difference Vsens and the temperature T [°C] from the detection signal. The control circuit 17 specifies the resistance value Rbridge of the copper pattern 61B from the temperature characteristic illustrated in FIG. 19 based on the temperature T [°C]. Subsequently, the control circuit 17 calculates the energization current IL based on the resistance value Rbridge and the potential difference Vsens. The control circuit 17 controls drive of any of the semiconductor relays 46A to 46D by, for example, outputting a control signal based on the energization current IL to any of the semiconductor relays 46A to 46D.

As described above, in the semiconductor relay 46 according to the present embodiment, the switching elements 32 are disposed on the electric path 4 between the high-voltage battery 2 and the high-voltage load 3 and on the electric path 5 used for energization from the charging inlet 7 to the high-voltage battery 2. Accordingly, effects same as those of the semiconductor relay 16 can be achieved, and in addition, when the number of electric paths in the vehicle current detection device 10 is increased, component sharing (standardization) can be achieved without using different semiconductor relays on the respective electric paths.

The vehicle current detection device 10 according to the present embodiment includes the semiconductor relay 46 disposed on the electric path 4 and configured to open and close the electric path 4, and the semiconductor relay 46 is additionally disposed on the electric path 5 between the high-voltage battery 2 and the charging inlet 7. Accordingly, effects same as those of the above-described semiconductor relay 46 can be achieved, and in addition, the size of the entire device can be reduced.

In the vehicle current detection device 10 according to the present embodiment, the semiconductor relays 46 disposed on the electric path 4 and the electric path 5 are housed in an identical housing, and thus the size of the entire device can be reduced.

In the vehicle current detection device 10 according to the present embodiment, the semiconductor relay 46 detects a physical quantity related to the energization current IL flowing through the electric paths 4 and 5, and thus effects same as those of the semiconductor relay 16 can be achieved.

In the above-described third embodiment, the charging inlet 7 is a connection portion to be connected with an external power source, but is not limited thereto, and may be able to be connected with an external load. In this case, the electric path 5 is connected with the external load through the charging inlet 7 and used for energization from the high-voltage battery 2 to the external load. When the charging inlet 7 is connected with the external load, electrical power of the high-voltage battery 2 can be supplied to the external load.

In the above-described third embodiment, the temperature sensor 57 is disposed on the copper pattern 61B with the die bonding member interposed therebetween, but is not limited to this configuration. Any heat conduction member that allows accurate measurement of the actual temperature of the copper pattern 61B is applicable.

In the above-described third embodiment, the control circuit 17 may be connected with, for example, an external ECU 6 and may output a control signal based on a signal received from the external ECU 6. The control circuit 17 may perform anomaly detection and anomaly determination of the semiconductor relays 46A to 46D based on detection signals received from the semiconductor relays 46A to 46D. In this case, the control circuit 17 may transmit, to the external ECU 6, the detection signals and information related to the existence of detected anomaly and a result of the anomaly determination.

In the above-described first to third embodiments, each switching element 32 is achieved by an electrical power MOS-FET, but is not limited thereto, and may be achieved by, for example, a transistor or an insulated gate bipolar transistor (IGBT).

In the above-described first to third embodiments, the semiconductor relay 16 includes the pair of switching elements 32A and 32B, but is not limited thereto, and may be achieved by one switching element having functions same as those of the pair of switching elements 32A and 32B or by a plurality of switching elements having the functions.

Reference Signs List

| 1A, 1B | vehicle current detection device |
|---|---|
| 2 | high-voltage battery |
| 3 | high-voltage load |
| 4 | electric path |
| 11 | housing |
| 12 | upper cover |
| 13 | lower cover |
| 14, 14A, 14B | input-side terminal |
| 15, 15A, 15B | output-side terminal |
| 16, 16A, 16B, 26 | semiconductor relay |
| 17 | control circuit |
| 18 | control substrate |
| 18a | through-hole |
| 19, 29 | detection section |
| 21 | positive-electrode-side signal |
| 22 | negative-electrode-side signal |
| 23 | control signal |
| 31 | bus bar |
| 30 | relay housing |
| 32, 32A, 32B | switching element |
| 33, 33A, 33B | voltage detection section |
| 34, 34A, 34B | first temperature sensor |
| 35 | second temperature sensor |
| 36 | control terminal |
| 37 | shunt switching element |
| IL | load current |

**Claims**

1. A semiconductor relay (26) comprising:

   at least one semiconductor switching element (32A, 32B) that is configured to be disposed on a first electric path (4) between a high-voltage power source (2) and a high-voltage load (3) configured to receive electrical power supply from the high-voltage power source (2), and is configured to open and close the first electric path (4);
   at least two detection sections (19A, 19B) configured to detect a physical quantity related to current flowing through the first electric path (4); and
   a conductive member (31) serving as part of the first electric path (4) and having a resistance value that changes in accordance with temperature change; wherein
   each of the detection sections (19A, 19B) includes:

      a temperature detection section (34A, 34B) configured to detect temperature of the conductive member (31), and
      a voltage detection section (33A, 33B) configured to detect potential difference between two points on the conductive member (31), and

   the two detection sections (19A, 19B) are disposed on the first electric path (4) with the semiconductor switching element (32, 32A, 32B) interposed between the two detection sections (19A, 19B).

2. A vehicle current detection device (1B) comprising:

the semiconductor relay (26) according to claim 1; and
a control circuit (17) configured to control the semiconductor relay (26), wherein
the control circuit (17) is configured to detect current flowing through the semiconductor relay (26) based on each physical quantity detected by the detection sections (19A, 19B).

**Patentansprüche**

1. Halbleiter-Relais (26), das umfasst:

wenigstens ein Halbleiter-Schaltelement (32A, 32B), das so ausgeführt ist, dass es auf einem ersten elektrischen Weg (4) zwischen einer Hochspannungs-Stromquelle (2) und
einer Hochspannungs-Last (3) angeordnet ist, die so ausgeführt ist, dass sie Stromzufuhr von der Hochspannungs-Stromquelle (2) empfängt, und so ausgeführt ist, dass es den ersten elektrischen Weg (4) öffnet und schließt;
wenigstens zwei Erfassungs-Teilabschnitte (19A, 19B), die so ausgeführt sind, dass sie eine physikalische Größe erfassen, die sich auf den auf dem ersten Stromweg (4) fließenden Strom bezieht; und
ein leitendes Element (31), das als Teil des ersten Stromweges (4) dient und einen Widerstandswert hat, der sich entsprechend Temperaturänderung ändert; wobei
jeder der Erfassungs-Teilabschnitte (19A, 19B) einschließt:

einen Temperaturerfassungs-Teilabschnitt (34A, 34B), der so ausgeführt ist, dass er Temperatur des leitenden Elementes (31) erfasst, und
einen Spannungserfassungs-Teilabschnitt (33A, 33B), der so ausgeführt ist, dass er Potentialdifferenz zwischen zwei Punkten an dem leitenden Element (31) erfasst, und

die zwei Erfassungs-Teilabschnitte (19A, 19B) auf dem ersten Stromweg (4) angeordnet sind, wobei das Halbleiter-Schaltelement (32, 32A, 32B) zwischen den zwei Erfassungs-Teilabschnitten (19A, 19B) angeordnet ist.

2. Fahrzeug-Stromerfassungsvorrichtung (1B), die umfasst:

das Halbleiter-Relais (26) nach Anspruch 1; sowie
eine Steuerungsschaltung (17), die zum Steuern des Halbleiter-Relais (26) ausgeführt ist, wobei
die Steuerungsschaltung (17) so ausgeführt ist, dass sie durch das Halbleiter-Relais (26) fließenden Strom auf Basis jeder durch die Erfassungs-Teilabschnitte (19A, 19B) erfassten physikalischen Größe erfasst.

**Revendications**

1. Relais semi-conducteur (26) comprenant :

au moins un élément de commutation semi-conducteur (32A, 32B) qui est configuré pour être disposé sur un premier chemin électrique (4) entre une source d'alimentation haute tension (2) et une charge haute tension (3) configurée pour recevoir une alimentation électrique provenant de la source d'alimentation haute tension (2), et qui est configuré pour ouvrir et fermer le premier chemin électrique (4) ;
au moins deux sections de détection (19A, 19B) configurées pour détecter une quantité physique relative au courant qui traverse le premier chemin électrique (4) ; et
un élément conducteur (31) qui fait partie du premier chemin électrique (4) et présentant une valeur de résistance qui change en fonction d'un changement de température ; dans lequel
chacune des sections de détection (19A, 19B) comprend :

une section de détection de température (34A, 34B) configurée pour détecter la température de l'élément conducteur (31), et
une section de détection de tension (33A, 33B) configurée pour détecter une différence de potentiel entre deux points sur l'élément conducteur (31), et

les deux sections de détection (19A, 19B) sont disposées sur le premier chemin électrique (4), avec l'élément de commutation semi-conducteur (32, 32A, 32B) interposé entre les deux sections de détection (19A, 19B).

2. Dispositif de détection de courant d'un véhicule (1B) comprenant :

le relais semi-conducteur (26) selon la revendication 1 ; et
un circuit de contrôle (17) configuré pour contrôler le relais semi-conducteur (26), dans lequel
le circuit de contrôle (17) est configuré pour détecter le courant qui traverse le relais semi-conducteur (26) sur base de chaque quantité physique détectée par les sections de détection (19A, 19B).

# FIG.1

# FIG.2

# FIG.3

# FIG.4

# FIG.5

EP 3 678 295 B1

# FIG.6

33

$$V_{sens}=R_{bus} * IL$$

# FIG.7

Rbus: RESISTANCE VALUE [$\Omega$] AT T [$^{\circ}$C]
$R_0$: RESISTANCE VALUE [$\Omega$] AT $T_0$ [$^{\circ}$C]
$\alpha$: TEMPERATURE COEFFICIENT [1/$^{\circ}$C]
T: TEMPERATURE [$^{\circ}$C]
$T_0$: REFERENCE TEMPERATURE [$^{\circ}$C]

$$R_{bus}=R_0\{1+\alpha(T-T_0)\}$$

BUS BAR RESISTANCE Rbus

TEMPERATURE T

FIG.8

EP 3 678 295 B1

# FIG.9

- - - CURRENT VALUE 1 ON INPUT SIDE

- - - - CURRENT VALUE 2 ON OUTPUT SIDE

——— DIFFERENCE BETWEEN CURRENT VALUES 1 AND 2

ANOMALY DETERMINATION THRESHOLD (UPPER LIMIT)

ANOMALY DETERMINATION THRESHOLD (LOWER LIMIT)

ANOMALY DETECTION

# FIG.10

29

Drain

Gate

D

D

G

G

S

S

# FIG.11

# FIG.12

# FIG.13

# FIG.14

# FIG.15

EP 3 678 295 B1

FIG.16

# FIG.17

53   61A   32A (32)   57   62B   61B   32B (32)   52   61A   62A   63

# FIG.18

56

32A(32)   C   D   32B(32)

D   S   IL→   Rbridge   ~61B   S   D

G   Vsens=Rbridge * IL   G

# FIG.19

Rbridge: RESISTANCE VALUE [$\Omega$] AT T [$^{\circ}$C]
$R_0$: RESISTANCE VALUE [$\Omega$] AT $T_0$ [$^{\circ}$C]
$\alpha$ : TEMPERATURE COEFFICIENT [1/$^{\circ}$C]
T: TEMPERATURE [$^{\circ}$C]
$T_0$: REFERENCE TEMPERATURE [$^{\circ}$C]

COPPER PATTERN
RESISTANCE Rpettern

$Rbridge=R_0\{1+\alpha(T-T_0)\}$

TEMPERATURE  T

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012085504 A
- JP H7177751 A
- US 2013229186 A1
- US 6845301 B2
- EP 2933643 A1